(19) Europäisches Patentamt
European Patent Office
Office européen des brevets

(11) **EP 3 940 124 B1**

(12) **EUROPÄISCHE PATENTSCHRIFT**

(45) Veröffentlichungstag und Bekanntmachung des Hinweises auf die Patenterteilung:
**03.01.2024   Patentblatt 2024/01**

(21) Anmeldenummer: **20185631.7**

(22) Anmeldetag: **14.07.2020**

(51) Internationale Patentklassifikation (IPC):
**C30B 29/06** *(2006.01)*    **C30B 15/10** *(2006.01)*

(52) Gemeinsame Patentklassifikation (CPC):
**C30B 29/06;** C30B 15/10

(54) **KRISTALLSTÜCK AUS MONOKRISTALLINEM SILIZIUM**

MONOCRYSTALLINE SILICON CRYSTAL ARTICLE

PIÈCE DE CRISTAL EN SILICIUM MONOCRISTALLIN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.01.2022   Patentblatt 2022/03**

(73) Patentinhaber: **Siltronic AG**
**81677 München (DE)**

(72) Erfinder:
• **Balanetskyy, Sergiy**
**09599 Freiberg (DE)**
• **Lehmann, Toni**
**09569 Oederan (DE)**

• **Mangelberger, Karl**
**5122 Ach (AT)**
• **Zemke, Dirk**
**5122 Ach (AT)**

(74) Vertreter: **Killinger, Andreas**
**Siltronic AG**
**Intellectual Property**
**Johannes-Hess-Straße 24**
**84489 Burghausen (DE)**

(56) Entgegenhaltungen:
**EP-A1- 1 997 940    EP-A1- 2 711 446**
**EP-A1- 2 725 122    EP-A1- 2 990 508**

**Beschreibung**

Gegenstand der Erfindung ist ein Einkristall aus Silizium, der zur Herstellung von Halbleiterscheiben aus Silizium besonders geeignet ist.

Monokristalline Halbleiterscheiben (auch Wafer genannt) sind die Grundlage der modernen Elektronik. Während der Herstellung von Bauelementen auf besagten Halbleiterscheiben werden thermische Prozesse mit mittlerweile recht komplexen Beschichtungsschritten durchgeführt.

Halbleiterscheiben, insbesondere Halbleiterscheiben aus Silizium, werden üblicherweise hergestellt, indem zuerst ein monokristalliner Stab mit Hilfe des sogenannten Float-Zone Verfahrens (FZ) oder des Czochralski Verfahrens (CZ) gezogen wird. Die so produzierten Stäbe werden mittels dafür geeigneter Sägen wie Drahtsägen, Innenlochsägen oder Bandsägen in Kristallstücke geteilt, welche dann üblicherweise in einer Drahtsäge oder Innenlochsäge zu Halbleiterscheiben verarbeitet werden.

Nach weiteren mechanischen, chemo-mechanischen und/oder chemischen Schritten kann optional eine Schicht mittels CVD aufgebracht werden.

Diese so hergestellten Halbleiterscheiben werden dann dem weiteren Bauelementprozess zur Verfügung gestellt.

Eine geeignete Qualitätssicherung gebietet den intensiven Einsatz von Analysemethoden, die über den Erfolg oder Misserfolg der durchgeführten Fertigungsschritte entscheiden. So werden typischerweise unterschiedliche Messmethoden teilweise nach einzelnen Behandlungsschritten eingesetzt, um einerseits den Herstellungsprozess zu kontrollieren und andererseits vermeintlich unbrauchbare Halbleiterwafer auszusortieren. Zur Bewertung einer Halbleiterscheibe wird dabei typischerweise immer nur das Ergebnis einer einzelnen Messmethode bzw. eines Messparameters herangezogen.

Werden Einkristalle gemäß der Czochralski-Methode (CZ-Methode) aus einer Schmelze gezogen, die in einem Quarztiegel gehalten wird, bildet das Tiegelmaterial die Quelle für interstitiellem Sauerstoff, der in den Einkristall und die daraus gewonnene Halbleiterscheibe eingebaut wird. Die Konzentration an interstitiellem Sauerstoff, die eingebaut wird, lässt sich recht genau kontrollieren, beispielsweise durch die Regelung des Drucks und des Durchflusses von Argon durch die Ziehapparatur oder durch das Abstimmen von Tiegel- und Keimkristalldrehung während des Ziehens des Einkristalls oder durch Anwendung eines Magnetfelds, das der Schmelze aufgeprägt wird, oder durch eine Kombination dieser Maßnahmen. Im Allgemeinen ist die gemessene interstitielle Sauerstoffkonzentration bei Kristallen, die nach der CZ Methode hergestellt wurden nicht kleiner als $5 \times 10^{16}$ AT/cm$^3$ (new ASTM).

Interstitieller Sauerstoff spielt eine wichtige Rolle bei der Bildung von BMD-Defekten (BMDs, Bulk Micro Defects). BMDs sind Sauerstoffpräzipitate, zu denen BMD-Keime im Zuge einer Wärmebehandlung wachsen. Sie wirken als interne Getter, also als energetische Senken für Verunreinigungen, und sind daher grundsätzlich von Vorteil. Eine Ausnahme bildet ihre Präsenz an Stellen, an denen beabsichtigt ist, elektronische Bauelemente unterzubringen. Um zu vermeiden, dass BMDs an solchen Stellen entstehen, kann eine epitaktische Schicht auf der Halbleiterscheibe abgeschieden und vorgesehen werden, die elektronischen Bauelemente in der epitaktischen Schicht unterzubringen.

Der Tiegel besteht üblicherweise aus einem Siliziumdioxid enthaltenden Material wie Quarz. Er wird in der Regel mit Bruchstücken und/oder mit Granulat aus polykristallinem Silizium gefüllt, das mit Hilfe eines um den Tiegel herum angeordneten Seitenheizers und eines unter dem Tiegel angeordneten Bodenheizers geschmolzen wird. Nach einer Phase der thermischen Stabilisierung der Schmelze wird ein einkristalliner Impfkristall in die Schmelze getaucht und angehoben. Dabei kristallisiert Silizium am von der Schmelze benetzten Ende des Impfkristalls. Die Kristallisationsgeschwindigkeit wird im Wesentlichen durch die Geschwindigkeit beeinflusst, mit der der Impfkristall angehoben wird (Kristallhubgeschwindigkeit) und von der Temperatur an der Grenzfläche, an der geschmolzenes Silizium kristallisiert.

Durch geeignete Steuerung dieser Parameter wird zunächst ein als Dünnhals ("neck") bezeichneter Abschnitt gezogen, um Versetzungen zu beseitigen, dann ein Konus förmiger Abschnitt des Einkristalls und schließlich ein zylindrischer Abschnitt des Einkristalls, von dem später die Halbleiterscheiben abgetrennt werden.

Wie beispielsweise in US-5 954 873 A beschrieben werden beim Kristallziehverfahren die entsprechenden Prozessparameter so eingestellt, dass eine radial homogene Defektverteilung im Kristall erreicht wird.

WO 98/45508 A1 ist eine von zahlreichen Veröffentlichungen, die beschreiben, wie der zeitliche Verlauf der Ziehgeschwindigkeit v experimentell ermittelt werden kann, um über die Kontrolle der Ziehgeschwindigkeit v zu erreichen, dass der Quotient v/G während des Wachstums des Einkristalls nahezu unverändert bleibt und der Einkristall in einem vorgesehenen Gebiet wachsen kann. Darüber hinaus sind Nachweismethoden zur Charakterisierung und Unterscheidung von $P_v$-Gebiet und $P_i$-Gebiet beschrieben.

Freiwerdende gasförmige Einschlüsse im Tiegelmaterial, Gas, das die Bruchstücke und/oder das Granulat umgibt, in der Schmelze entstehendes Siliziumoxid und Gas, das in die Schmelze diffundiert, gelten als mögliche Ursachen für das Entstehen von "Pinhole"-Defekte genannten Hohlräumen im Einkristall (nicht zu verwechseln mit COPs). Sie entstehen, wenn Gasbläschen zur Grenzfläche zwischen dem wachsenden Einkristall und der Schmelze gelangen und der Einkristall um sie herum kristallisiert. Schneiden die Trennebenen beim Abtrennen der Halbleiterscheiben die Hohlräume, haben die entstehenden Halbleiterscheiben kreisrunde Vertiefungen oder Löcher mit einem Durchmesser, der typischerweise einige Mikrometer bis einige Millimeter betragen kann. Halbleiterscheiben, in denen solche Hohlräume vorhanden sind, sind als Substratscheiben zur Herstellung von elektronischen Bauelementen unbrauchbar.

Gemessen kann die Konzentration der entstandenen Pinholes an Stabstücken beispielsweise mit Hilfe der Raster-Ultraschall-Methode werden, die zum Beispiel in DE 102 006032431 A1 beschrieben wurde. Detektiert werden dabei Pinholes ab einem Durchmesser von etwa 50 $\mu$m. Das Bestimmen der jeweiligen genauen Größe der Pinholes ist mit diesem Verfahren mit größeren Messfehlern behaftet.

In US-9665931 A1 wird ein entsprechendes Verfahren beschrieben, wie die Konzentration und die jeweilige Größe von Pinholes an Halbleiterscheiben bestimmt werden kann. Mit diesem Verfahren kann die Größe der Pinholes sehr genau festgestellt werden.

Um die Größe von Pinholes in Stabstücken genau messen zu können, wird gemäß Stand der Technik das zu vermessende Stabstück der Messung nach

DE 102 006 032431 A1 unterzogen und dabei die Koordinaten der gefundenen Pinholes gespeichert.

Anschließend wird der Bereich, der entsprechende Pinholes enthält, in Halbleiterscheiben aufgeschnitten und mittels der in US-9665931 A1 beschriebenen Methode analysiert. Die Größe der so gefundenen Pinholes kann so mit einer Messungenauigkeit von wenigen Prozent bestimmt werden.

Das Aussortieren von Halbleiterscheiben ist berechtigt, da erhebliche Kosten entstehen, wenn erst bei der Behandlung der Halbleiterscheibe im Bauelementprozess erkannt wird, dass die Halbleiterscheibe ungeeignet oder fehlerhaft ist. Andererseits führt es unweigerlich zu einem wirtschaftlichen Schaden beim Hersteller der Halbleiterscheiben, falls Material fälschlicherweise als untauglich eingestuft wird.

Eine Halbleiterscheibe kann mit unterschiedlichen Defekten behaftet sein. Sowohl der Defekttyp als auch dessen Erscheinung (Position und Erscheinungsform) entscheiden in Abhängigkeit vom Bauelementprozess, ob der Defekt als schädlich oder für den Bauelementprozess unkritisch einzuordnen ist.

Beispielsweise können Pinholes im Inneren (also fern der Oberfläche) einer Halbleiterscheibe vorhanden sein, ohne dass irgendeine Auswirkung auf den Bauelementprozess zu beobachten ist. Befindet sich ein Pinhole hingegen an oder in der Nähe der Oberfläche, entfaltet er sehr wohl eine schädliche Wirkung im Bauelementprozess.

In US 2008 / 0032429 A1 wird sich dieser Problematik angenommen und eine Methode für ein Messverfahren beschrieben, welches bei Auftreten eines Defektes zusätzliche Bilder von dem Defektbereich auf der Halbleiterscheibe anfertigt und verwendet, um die Defektart in dieser Region festzulegen. So wird ein einmal vom System erkannter Fehler nochmals mittels weiteren Messdaten desselben Messgerätes vermessen und so die Entscheidung entweder verifiziert oder falsifiziert. Dies erfordert erhöhten Analyseaufwand und damit erhöhte Kosten.

In US 2008 / 0163140 A1 werden nach dem Erkennen eines Defektes die Koordinaten des Defektes auf der Halbleiterscheibe gespeichert und der Defekt gezielt einem zweiten Messverfahren unterworfen. Durch diesen Messschritt soll der Defekttyp eindeutig identifiziert werden. Auch hier entstehen durch das Anwenden eines weiteren Messverfahrens erhöhte Kosten.

Beide im Stand der Technik beschriebenen Verfahren sind in der Lage einen einmal gefundenen Defekt (Fehler) zu verifizieren oder zu falsifizieren. Man spricht hier von einem Defekt-Review. Beide Methoden zielen darauf ab, einen einmal detektierten Defekt gezielt mit einer zusätzlich durchgeführten Messung eindeutig zu identifizieren.

Hintergrund dieser zusätzlichen Messung ist, dass derzeit standardmäßig verwendete Messmethoden nur eingeschränkt eine geeignete Klassifizierung leisten.

Jede zusätzliche Messmethode generiert einerseits Kosten und zum anderen kann sie zu Veränderungen der Halbleiterscheibe (zum Beispiele zu Kontamination) führen. Diese wiederum schließen eine Verwendung der so untersuchten Halbleiterscheibe im Bauelementprozess aus. Diese Methoden können daher in der Massenherstellung von Halbleiterscheiben nicht zum Einsatz gebracht werden.

Auch wurden bereits eine Reihe von Vorschlägen veröffentlicht, wie die Bildung Pinholes während des Kristallziehens unterdrückt werden kann. Viele dieser Vorschläge richten den Fokus auf die Verbesserung der Eigenschaften des Tiegelmaterials.

Auch gibt es Vorschläge (z.B.: EP 247 1980 A1), die das Einrichten des Tiegels optimieren, um so Verletzungen des Tiegels und somit das Entstehen von Gasblasen in der Schmelze und damit Pinholes im Einkristall vermeiden.

Andere Vorschläge konzentrieren sich auf die Unterdrückung oder Beseitigung von Pinholes während des Zeitraums des Schmelzens der Bruchstücke und/oder des Granulats. So wird beispielsweise in der US 2011/304081 A1 empfohlen, mittels geeigneter zeitlich veränderter Leistungsverteilung der verwendeten Heizer den Tiegel so zu schonen, dass die Dichte der auftretenden Pinholes im Kristall reduziert wird.

Um die gewünschten (Defekt-) Eigenschaften des gezogenen Kristalls zu erreichen, ist es notwendig, die Verteilung der Heizleistung entsprechend in festem Verhältnis einzustellen. Dies widerspricht zum Beispiel dem in DE10 339 792 A1 vorgeschlagenen Verfahren. Es ist damit unmöglich beide Ziele (niedrige Konzentration von Pinholes und gewünschte Defekteigenschaften) zu erreichen.

In der JP-5009097 A2 ist ein Verfahren zur Herstellung eines Einkristalls aus Silizium beschrieben, bei dem beim Aufschmelzen des Polysiliziums der Druck in der Kristallziehanlage auf einen Druck von 5 bis 60 mbar reduziert wird und beim Ziehen des Kristalls der Druck 100 mbar und mehr beträgt.

In der US 2011/214603 A1 wird eine Methode zur Herstellung eines Einkristalls aus Silizium beschrieben, bei der die Leistung der Heizer beim Aufschmelzen höher eingestellt wird als beim anschließenden Kristallziehen. Zusätzlich wird der Druck beim Aufschmelzen zu 30 mbar oder kleiner eingestellt, was kleiner ist als beim anschließenden Kristallziehen.

Weitere Tiegel und Verfahren zur Herstellung von Einkristallen aus Silizium sind in der EP2725122 und in der EP2711446 beschrieben.

Die Erfinder haben erkannt, dass offenbar defektfreies Halbleitermaterial eine verhältnismäßig hohe Konzentration an Pinholes enthält. Die im Stand der Technik beschriebenen Techniken vermögen einen Teil der Problematik zu lösen, es zeigte sich aber, dass die nach dem Stand der Technik hergestellten Halbleiterscheiben immer noch eine sehr hohe Ausfallwahrscheinlichkeit bei der Herstellung von Bauelementen haben.

Auch haben die Erfinder erkannt, dass die im Stand der Technik beschriebenen Methoden weitere Nachteile aufweisen. Insbesondere konnte festgestellt werden, dass die gezogenen Einkristalle erhöhte Verunreinigungswerte bezüglich Kohlenstoff und Eisen aufwiesen

Die Erfinder haben zusätzlich erkannt, dass es mit den im Stand der Technik vorgeschlagenen Verfahren nicht möglich ist, Einkristalle nach Czochralski herzustellen, die sowohl eine sehr geringe Dichte großer Pinholes, als auch eine sehr niedrige Kontamination von Eisen und Kohlenstoff und dabei gleichzeitig die gewünschten Defekteigenschaften (defektfrei) aufweisen.

Die Aufgabe der Erfindung ist es daher, Kristalle aus Silizium und daraus produzierte Halbleiterscheiben zur Verfügung stellen, die die oben beschriebenen Nachteile nicht aufweisen.

Die Aufgabe wird gelöst durch ein Kristallstück aus monokristallinem Silizium, das zur Herstellung von Halbleiterscheiben vorgesehen ist, mit einer Länge von nicht weniger als 8 cm und nicht mehr als 50 cm und einem Durchmesser nicht kleiner als 280 mm und nicht größer als 320 mm, dadurch gekennzeichnet, dass der Anteil der daraus hergestellten Halbleiterscheiben, die frei sind von Pinholes mit einer Größe von nicht mehr als 30 $\mu$m und größer als 7 $\mu$m, größer ist als 98%.

Ferner wird die Aufgabe gelöst durch die in den abhängigen Ansprüchen beschriebenen Produkten und Verfahren. Die bezüglich der vorstehend aufgeführten Ausführungsformen des erfindungsgemäßen Verfahrens angegebenen Merkmale können entsprechend auf die erfindungsgemäßen Produkte übertragen werden. Umgekehrt können die bezüglich der vorstehend ausgeführten Ausführungsformen der erfindungsgemäßen Produkte angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert.

**Begriffsdefinitionen**

Unter **MWS** ("Multi Wire Saw") wird das gleichzeitige Abtrennen von Halbleiterscheiben mittels eines Sägedrahtes von einem Kristallstück verstanden. Eine exemplarische Beschreibung dieses Verfahrens wird in WO18149631 A1 gegeben.

Unter **ENG** ("Edge Notch Grinding") wird das Verfahren zum Kantenverrundung verstanden, das exemplarisch in DE102013212850 A1 wiedergegeben wird.

Unter **CMP** ("chemical mechanical polishing") versteht man das chemisch mechanische Polieren, bei dem unter Verwendung eines losen Korns und geeigneter chemischer Hilfsstoffe ein Polierabtrag auf einer Seite der Halbleiterscheibe hervorgerufen wird. Weitere Details werden beispielsweise in der DE 10 2008 045 534 B4 beschrieben.

Das Doppelseiten-Polieren (**DSP**) ist ein Verfahren aus der Gruppe der chemo-mechanischen Bearbeitungsschritte (**CMP**). Eine DSP-Bearbeitung von Halbleiterscheiben ist beispielsweise beschrieben in US 2003/054650 A1 und eine dafür geeignete Vorrichtung in DE 100 07 390 A1. Die **DSP** umfasst ein chemisches Ätzen mittels einer Lauge und ein mechanisches Erodieren mittels im wässrigen Medium dispergierten losen Korns, welches durch ein Poliertuch, das keine in Kontakt mit der Halbleiterscheibe gelangenden Hartstoffe enthält, in Kontakt mit der Halbleiterscheibe gebracht wird und so unter Druck und Relativbewegung einen Materialabtrag von der Halbleiterscheibe bewirkt.

**CVD** steht für Chemical Vapor Deposition und wird exemplarisch in WO19020387 A1 beschrieben.

Unter **DDG** (Doppelseitenschleifen) ist eine Methode zum mechanischem Abtrag mit Hilfe von gebundenem Korn in einem Träger beispielsweise einer Schleifscheibe gemeint. Beispielhaft wird dieses Verfahren in DE 10 2017 215 705 A1 beschrieben.

Unter **Etch** (Ätzen) wird der chemisch- oder alkalisch-induzierte Abtrag der Halbleiter verstanden. Beispielhaft wird dieses Verfahren in US7829467 B2 beschrieben.

Unter **Edge Round** (Kantenverrunden) wird das mechanische Verrunden der Kanten der Halbleiterscheibe verstanden.

Unter **Edge Polish** (Kantenpolieren) wird das Polieren der Kanten der Halbleiterscheibe verstanden.

Unter Widerstandsmessung (**Widerstand**) wird das Messen des elektrischen Widerstandes des monokristallinen Siliziums verstanden. Bevorzugt wird hierfür die sogenannte vierspitzen Messmethode verwendet, es können aber auch andere Methoden verwendet werden.

Unter **Lichtstreuung** versteht man Messmethoden wie zum Beispiel MO6, MO4, LLS, IR-LST (localized light scattering). Bei dieser Methode wird das zu untersuchende Objekt - also der Silizium Wafer - mit einem Lichtstrahl abgerastert und das an Unregelmäßigkeiten der Oberfläche oder im Volumen gestreute und/oder das reflektierte Licht mittels Detektor aufgezeichnet. Im Falle von gestreutem Licht spricht man von Dunkelfeld-Inspektion, die Detektion des reflektierten Lichtes wird als Hellfeld-Messung bezeichnet. (Siehe auch SEMI Standard M52).

Mittels der Infrarot-Depolarisation (**SIRD**) wird eine Halbleiterscheibe mittels Infrarotstrahl abgerastert. Dabei werden Inhomogenitäten in der Polarisation des reflektierten oder transmittierten Laserlichts ortsaufgelöst aufgezeichnet, um mögliche lokale Verspannungen im Material festzustellen.

Bei Ultraschallmessung (**Ultraschall**) wird eine Probe mit Ultraschall durchstrahlt. Trifft die Schallwelle auf Unregelmäßigkeiten kommt es zum zur Reflexion, welche detektiert wird. Die Probe wird hier ebenfalls abgerastert. Zusammen mit der Laufzeitmessung der Welle, kann die lokale Position der Unregelmäßigkeit exakt bestimmt werden.

Lebensdauermessung der Minoritätsladungsträger (**Lebensdauer**), Bestimmung der Rekombinations-Lebensdauer von erzeugten freien Ladungsträger in Zustände unterhalb der Fermi-Energie unter Einhaltung der Impulserhaltung auf Kristalldefekte und Verunreinigungen. (Referenz: SEMI Standard MF1535)

Messung der freien Weglänge der Minoritätsladungsträger (**freie Weglänge**), Berechnet sich aus der Lebensdauer und der freien Diffusionskontante (Materialkonstante, Referenz: SEMI Standard MF 391)

Messung der lokalen Geometrie (**lokale Geometrie**): Bei dieser Methode wird entweder mittels eine kapazitive Messung, mittels Interferometrie oder mittels Triangulation die lokale Variation der Ebenheit und/oder Dicke der Probe bestimmt. (Siehe auch SEMI Standard M49)

**Mikroskopie** (Elektronenmikroskopie, optische Mikroskopie im sichtbaren Lichtwellenbereich, Mikroskope werden eingesetzt, um nach entsprechenden Fertigungsschritten spezielle Bereiche der Siliziumscheibe routinemäßig zu kontrollieren. Hierzu zählen insbesondere der Randbereich, der Notchbereich, Bereiche der Lasermarkierung und Kontaktstellen von Wafer-Handlings- und Auflagesystemen.

**Massenspektroskopie** und Röntgen-Fluoreszenz wird routinemäßig eingesetzt um - teilweise lokal aufgelöst Fremdatome im Silizium zu identifizieren und deren Konzentration zu ermitteln.

**FTIR** kann eingesetzte werden, um die Dicke einer Schicht (z.B. von epitaktischen oder Oxid-Schichten) als auch - über Spektralanalyse- die Konzentration von Fremdatomen wie O, C, H, N zu ermitteln.

**LLS** bezeichnet ein mittels Lichtstreuung an einer Waferoberfläche erkannten Lichtstreupunkt (Localized Light Scattering).

### Kurzbeschreibung der Figuren

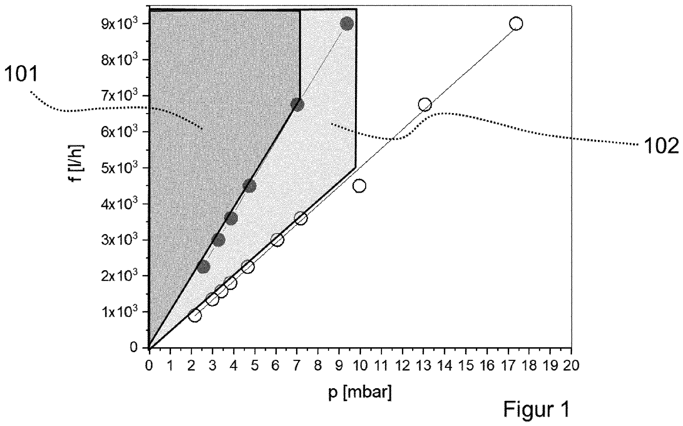

**Figur 1** zeigt die Relation des Durchflusses f [l/h] des Inertgases als Funktion des Anlagendrucks p [mbar]. Die mit (102) bezeichnete Fläche stellt dabei einen bevorzugten und die mit (101) bezeichnete Fläche einen besonders bevorzugten Bereich für das Verhältnis zwischen Druck und Durchfluss beim Aufschmelzendes Silizium s dar.

Der Fachmann versteht unter der Einheit l/h (Liter pro Stunde) Normliter pro Stunde, also das Volumen pro Zeiteinheit, das das Gas beim Normaldruck haben würde.

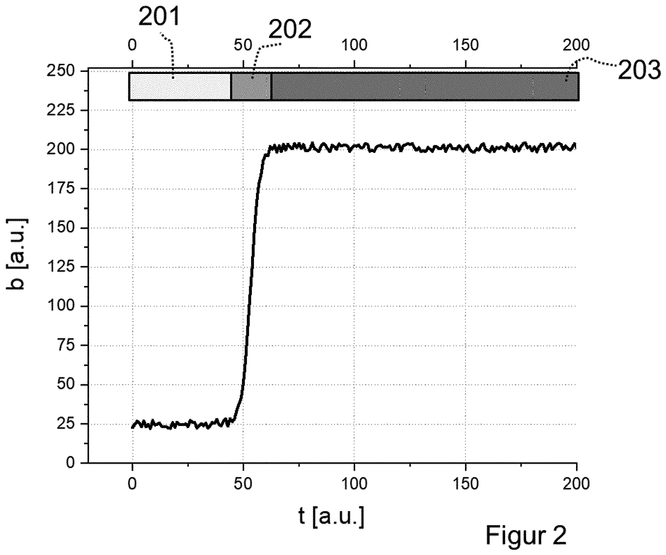

**Figur 2** zeigt einen typischen zeitlichen Verlauf der mit einer Kamera gemessenen Helligkeit beim Erhitzen des Silizium s in Helligkeitswerten b in jeweils relativen Einheiten. Der Bezeichner (201) steht dabei für den Bereich, bei dem das Silizium noch fest ist und (203) den Bereich, bei dem das Silizium schon komplett flüssig vorliegt. Der Bezeichner (202) steht für den Bereich, bei dem das Silizium sowohl noch fest als auch schon teilweise flüssig vorliegt.

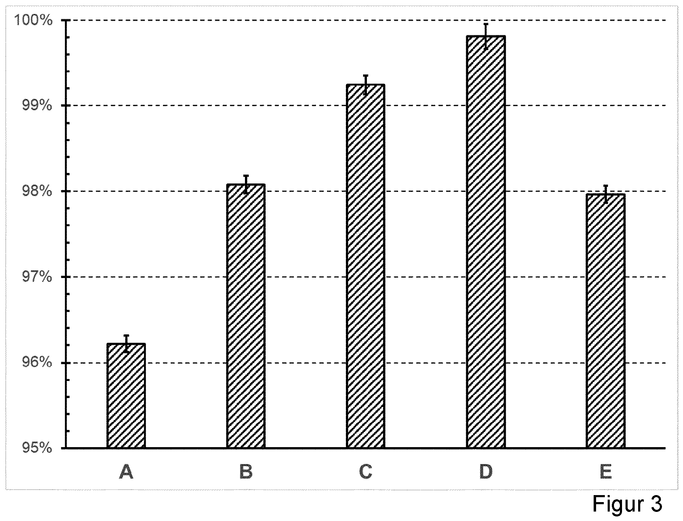

Die Ordinate in **Figur 3** zeigt den Anteil der Halbleiterscheiben in Prozent, der aus einem Kristallstück gewonnen wurde und keine Pinholes aufweist. Die Bezeichner **A** mit **E** stehen dabei für unterschiedliche, im Weiteren erläuterte Versuchsbedingungen.

### Detaillierte Beschreibung erfindungsgemäßer Ausführungsbeispiele

Es wurden jeweils mehrere Kristalle aus einem Tiegel mittels dem Ziehverfahren nach Czochralski gezogen. Es wurden sowohl die mittlere freie Weglänge der Minoritätsladungsträger (SPV) als auch die Länge des nicht versetzten Kristalls gemessen. Die Länge des nicht versetzten Anteils des Kristalls wurde dabei in Relation zur theoretisch erreichbaren Gesamtlänge gesetzt.

Beim Kristallziehen wurden aus dem Stand der Technik bekannte Mittel eingesetzt, um defektfreie Kristalle herzustellen. Dies kann prinzipiell entweder mit einem CUSP Magnetfeld, einem horizontalen Magnetfeld oder mit einem magnetischen Wanderfeld erfolgen. Ferner werden hierfür die Kristalldrehung und Tiegeldrehung entsprechend eingestellt.

Es wurde die charakteristische mittlere freie Weglänge der Minoritätsladungsträger in Relation zur gemessenen maximalen gemessenen mittleren freien Weglänge gesetzt. Diese Maßzahl dient im Folgenden als Qualitätskriterium für eventuelle Verunreinigungen, die im Kristall vorhanden sein könnten, die die später auf dem Silizium gefertigten Bauelemente zu stören. Theoretisch könnten auch andere Maßzahlen für die Qualität der Kristalle verwendet werden. Als Beispiele hierfür ist eine Lebensdauermessung nach µPCD oder auch eine chemische Analytik des erhaltenen Siliziums mit ICP-MS. Dem Fachmann stehen hier einige geeignete Verfahren zur Verfügung.

Die Erfinder haben die oben beschriebenen Methoden zur Messung als die geeigneten und vor allem als leicht zugänglich identifiziert.

Die Messung der Konzentration an Kohlenstoff in Silizium wurde mit Hilfe der Gasfusionsanalyse durchgeführt, die zum Beispiel in DE 1020 14217514 A1 beschrieben wurde. Alternativ kann auch FTIR verwendet werden.

Die Eisenkonzentration wurde mit Hilfe der ICPMS (Inductively Coupled Plasma - Mass Spectrometry) Methode gemessen. Sie kann auch mit NAA (Neutronenaktivierungsanalyse) mit geeigneter Kalibrierung durchgeführt gemessen werden.

Jeder so gezogene monokristalline Stab wurde dabei mittels einer Bandsäge in Stabstücke zerteilt, und anschließend in Wafer geschnitten und diese sowohl auf Pinholes, Defekteigenschaften als auch auf Verunreinigungen (Kohlenstoff, Eisen) hin untersucht.

Die Erfinder haben erkannt, dass die Verwendung von Tiegel, die nach dem Stand der Technik gefertigt wurden, deutliche Nachteile aufweisen, wenn ein Tiegel verwendet wird, um mehrere Kristalle nacheinander nach der Czochralski-Methode zu ziehen. Außerdem erschien es umso schwieriger, je länger das Ziehverfahren dauerte.

Wenn Kristalle mit einem Tiegel gezogen werden, der -wie im Stand der Technik beschrieben- aus natürlich gewonnenem SiO$_2$ hergestellt und dessen Innenseite mit einer Barium enthaltenden Komponente beschichtet wurde, zeigte sich, dass die Länge des versetzungsfreien Anteils der Kristalle hoch bleibt, dennoch ist ein erhebliches Absinken der mittleren freien Weglänge ersichtlich. So sinkt die mittlere freie Weglänge im Mittel auf 70% des Anfangswertes ab. Es ist also nicht gegeben, dass Kristalle mit gleicher Qualität mit einem Tiegel hergestellt werden können.

Werden Kristalle mit einem Tiegel gezogen werden, der -wie im Stand der Technik beschrieben- aus synthetisch gewonnenem SiO$_2$ hergestellt wurde und dessen Innenseite mit einer Barium enthaltenden Komponente beschichtet wurde zeigt sich eine deutlich erhöhte Streuung der gemessenen freien Weglänge.

Selbst unter optimalen Bedingungen zeigt zum Beispiel ein Kristall eine um im Mittel 10% kleinere mittlere freie Weglänge. Kristalle dieser Qualität sind für die Halbleiterindustrie nicht ausreichend. Auch die Länge des versetzungsfreien Anteils der so gewonnen Kristalle zeigt eine inakzeptable Streuung und würde für einen entsprechenden wirtschaftlichen Schaden führen.

Die Erfinder haben als erstes das Tiegelmaterial als Ursache für die gemessenen Defizite identifiziert und umfangreiche Versuche unternommen, die Defizite zu eliminieren.

Aus dem Stand der Technik ist bekannt, dass β-Cristobalit eine höhere Schmelztemperatur als Quarz aufweist. Ferner ist bekannt, dass es bestimmte Kristallisationspromotoren gibt, die manchmal die Erzeugung von β-Cristobalit begünstigen.

Auch ist bekannt, dass Quarztiegel aus synthetisch gewonnenen SiO$_2$ andere Eigenschaften aufweisen, als Quarztiegel aus natürlich gewonnenen SiO$_2$.

Die Erfinder entdeckten überaschenderweise, dass ein Quarzglastiegel, mit einer Innenseite, auf der sich eine Innenschicht aus Quarzglas befindet, die eine Oberfläche bildet, wobei die Innenschicht mit einem Kristallisationspromotor versehen ist positive Eigenschaften in Bezug auf das mehrfache Kristallziehen aus einem Tiegel zeigt, nämlich dann, wenn die Konzentration von synthetisch gewonnenen SiO$_2$ C in einer Entfernung von der Oberfläche größer ist als die Konzentration von synthetisch gewonnenen SiO$_2$ in einer weiteren Entfernung von der Oberfläche.

Besonders bevorzugt wirken dabei die Stoffe Barium oder Strontium Kristallisationspromotor, wobei Barium ganz besonders bevorzugt wird.

Die Erfinder haben ferner erkannt, dass es von Vorteil ist, wenn die Konzentration von synthetisch gewonnenen SiO$_2$ C größer ist als 90% wenn der Abstand zur Oberfläche kleiner ist als 0,4 mm beträgt.

Weitere Versuche ergaben in unerwarteter Weise, dass, wenn für die Konzentration von synthetisch gewonnenen SiO$_2$ in Abhängigkeit des Abstandes d folgende Relationen gilt:

$$C\,[\%] <= 100 - (d\,[mm] - 0{,}25) \times 30$$

und

$$C\,[\%] >= 100 - (d\,[mm] + 0{,}25) \times 80$$

es sowohl in Bezug auf die Qualität (SPV) als auch auf den Anteil versetzungsfreien Länge des Kristalls sich Vorteile ergeben.

Den Erfindern gelang es, den Bereich durch weitere Experimente etwas einzuengen und fanden, dass, wenn für die Konzentration von synthetisch gewonnenen $SiO_2$ in Abhängigkeit des Abstandes d folgende Relationen gilt

$$C\,[\%] <= 100 - (d\,[mm] + 0,1) \times 80$$

und

$$C\,[\%] >= 100 - (d\,[mm] - 0,05) \times 36,$$

es sowohl in Bezug auf die Qualität (SPV) als auch auf den Anteil versetzungsfreien Länge des Kristalls sich weitere Vorteile ergeben.

Besonders bevorzugt ist dabei die Konzentration des Kristallpromotors kleiner ist als 1 ppba und größer ist als 0,05 ppba bezogen auf Silizium.

Einkristalle, die unter Verwendung des eben beschriebenen Tiegelmaterials hergestellt wurden, wurden anschließend zu Halbleiterscheiben verarbeitet.

Die Erfinder haben dabei erkannt, dass die Verarbeitung der Kristallstücke zu Halbleiterscheiben modifiziert werden müsse, um schädliche Pinholes besser zu detektieren und so die entsprechenden übergreifenden Maßnahmen besser und schneller optimieren zu können.

Üblicherweise werden nach den entsprechenden Fertigungsschritten Messungen durchgeführt, die dazu führen, dass die Halbleiterscheibe entweder aussortiert wird oder zum nächsten Bearbeitungsschritt zugelassen wird.

Dies wurde dahingehend modifiziert, dass nach den einzelnen Fertigungsschritten zur Herstellung von Halbleiterscheiben Messungen mit den dafür geeignet erscheinenden Messmethoden durchgeführt werden, deren Ergebnisse in einer Datenbank gespeichert werden. Die einzelne Halbleiterscheibe wird dabei unabhängig vom Messergebnis immer zum nächsten vorgesehenen Fertigungsschritt zugelassen.

Als Messergebnis wird dabei die Art der möglichen Auffälligkeit oder des Fehlers, die lokalen Koordinaten dieser Auffälligkeit oder des Fehlers, die verwendete Messmethode (inklusive Ausprägung) und die Art des Fertigungsschrittes gesehen.

Die Erfinder haben erkannt, dass die Gesamtheit der Messergebnisse nach allen durchgeführten Fertigungs- und deren zugeordneten Messungen zu einer wesentlich besseren Materialbeurteilung führt.

Diese Methode erweist sich als sehr vorteilhaft gegenüber der Beurteilung der Daten einzelner Messergebnisse nach dem jeweiligen Fertigungsschritt. Die Kombination von Messdaten nach unterschiedlichen Bearbeitungsschritten erlaubt es sowohl, den Ursprung und damit die Natur eines Defekts wie auch dessen Position auf bzw. in der Halbleiterscheibe genauer festzulegen. Die Qualität der Identifikation von Defekten und die damit verknüpfte Beurteilung einer Halbleiterscheibe hinsichtlich der Tauglichkeit für den Bauelementprozess kann damit optimiert werden.

Die hergestellten Kristallstücke wurden mit einer Ultraschallmessung untersucht, wobei die Ergebnisse (Koordinaten der möglichen Unregelmäßigkeiten des Kristalls) gespeichert wurden. Anschließend wurden sie unabhängig von den schon gewonnenen Ergebnissen mittels MWS zu Halbleiterscheiben geschnitten. An den so gewonnenen Halbleiterscheiben wurden anschließend IR Messungen durchgeführt, deren Ergebnisse wiederum ortsaufgelöst gespeichert wurden.

An Stellen, an denen die IR Messung Auffälligkeiten zeigte, wurde als Kontrolle zusätzlich wie im Stand der Technik vorgeschlagen als Zweitmessung ein Defekt Review mit einer weiteren IR Messung mit höherer Auflösung durchgeführt. Dabei wurden diese Daten verwendet um, wie im Stand der Technik vorgeschlagen, eine Beurteilung der Auffälligkeiten zu erhalten. Aber im Gegensatz zum Stand der Technik wurden die Halbleiterscheiben, die einen möglicherweise schädlichen Defekt zeigten nicht verworfen, sondern den nächsten Fertigungsschritten unterworfen. Dasselbe Prinzip wurde auch bei den nach folgenden Schritten angewandt. Die so gewonnenen zusätzlichen Daten wurden am Ende als Datenbasis für die spätere Überprüfung der erfinderischen Methode verwendet.

Nach einer Doppelseitenpolitur (DSP) wurden die gewonnenen Halbleiterscheiben einer IR-Messung unterworfen und die Daten wiederum ortsaufgelöst gespeichert.

Nach einer weiteren Behandlung der Halbleiterscheiben mit CMP wurden die Halbleiterscheiben einer SIRD-Messung unterzogen und deren Daten ortsaufgelöst gespeichert. Zudem wurden die Halbleiterscheiben nach CMP einer Lichtstreumessung der Vorderseite und der Rückseite unterworfen, deren Daten ortsaufgelöst gespeichert wurden.

Einige der so gewonnenen Halbleiterscheiben wurden mittels einer CVD Behandlung weiterverarbeitet und anschließend mittels einer Lichtstreumessung an der Vorder- und Rückseite untersucht, wobei alles Daten wiederum ortsaufgelöst gespeichert wurden.

Eine Zusammenfassung der verwendeten Fertigungsschritte mit den hierzu durchgeführten Messungen ist in Tabelle 1 gezeigt.

Tabelle 1

| # | Fertigungsschritt | Messung nach dem Fertigungsschritt |
|---|---|---|
| 1 | Kristallziehen | Ultraschallmessung:<br>Detektion von Unregelmäßigkeiten im Kristall |
| 2 | MWS | IR-Messung<br>Detektion von Unregelmäßigkeiten an/in der Siliziumscheibe |
| 3 | DSP | IR-Messung<br>Detektion und teilweise Klassifikation von Unregelmäßigkeiten an/in der Siliziumscheibe |
| 4 | CMP | SIRD-Messung |
| 5 | CMP | Lichtstreumessung an Vorder-, Rückseite und Kante<br>Detektion und teilweise Klassifikation von Unregelmäßigkeiten an/in der Siliziumscheibe |

Am Ende wurden alle Messergebnisse in Gesamtschau analysiert.

Überraschenderweise konnten die Erfinder dabei feststellen, dass die kleinste Größe der so gefundenen Pinholes etwa 7 $\mu$m beträgt. Ferner wuurde gefunden, dass die maximale Größe der gefndenen Pinholes 30 $\mu$m beträgt.

Alternativ, jedoch wesentlich zeitaufwändiger und daher nicht bevorzugt, können die erhaltenen Halbleiterscheiben auch mittels Infrarotmikroskopie (zum Beispiel mit SIRD in Transmission) auf das Auftreten von Pinholes untersucht werden. Die minimale Größe der gemessenen Pinholes beträgt hierbei ebenfalls 7 $\mu$m.

Die Erfinder stellten beim Betrachten der gesamten Ergebnisse fest, dass trotz des verwendeten optimierten Tiegelmaterials immer noch Pinholes in erheblichen Maße dafür sorgen, dass der Anteil der Hableiterscheiben eines Kristallstücks, der nicht für den Bauelementprozess geeignet sind, etwa 3,8% beträgt. Figur 3 zeigt in Säule A den Anteil der Halbleiterscheiben ist, die ohne gemessene Pinholes sind (etwa 96,2%). Die gemessene Verunreinigung an Eisen wurde mit kleiner $1,0 \times 10^{10}$ at/cm$^3$ und die Verunreinigung an Kohlenstoff wurde mit maximal $7 \times 10^{14}$ at/cm$^3$ festgestellt. Es mit den verwendeten Ziehverfahren konnte eine Sauerstoffkonzentration zwischen $1 \times 10^{17}$ und $7 \times 10^{17}$ at/cm$^3$ (new ASTM) eingestellt werden. Der Widerstand wurde zwischen 1 mOhmcm und 1 Ohmcm eingestellt.

Unter Verwendung des modifizierten Tiegelmaterials wurde nun das Einrichten und Aufschmelzen des Polysiliziums im Tiegel modifiziert.

Vorteilhaft erwies sich das Verwenden von Silizium mit einer mittleren massenbezogenen spezifischen Oberfläche von kleiner als 2 cm$^2$/g.

Ganz besonders bevorzugt wird der Tiegel im Abstand kleiner als 5 cm und größer als 2 cm von der Tiegelwand mit Polysilizium mit einer massenspezifischen Oberfläche von kleiner als 1 cm$^2$/g eingerichtet. Der Rest des Tiegelvolumens wird mit Polysilizium mit einer massenspezifischen Oberfläche von größer als 1 cm$^2$/g und kleiner als 5 cm$^2$/g eingerichtet. Das Endergebnis ist in Figur 3 in Säule E gezeigt. Es sind etwa 98% der Wafer frei von Pinholes. Auch diese Maßnahme also verbessert die Ausbeute.

Beim Schmelzen des Polysiliziums wird ein Druck in der Kristallziehanlage von bevorzugt nicht größer als 10 mbar eingestellt. Gleichzeitig wird bevorzugt der gesamte Durchfluss f eines Spülgases durch die Ziehanlage so eingestellt, dass er größer ist als der Durchfluss f [l/h] multipliziert mit 160.

Figur 1 zeigt dabei das bevorzugte Fläche aus Druck p und Durchfluss f.

Besonders bevorzugt wird der gesamte Durchfluss eines Spülgases durch die Ziehanlage so eingestellt, dass er größer ist als der Durchfluss f [l/h] multipliziert mit 400 und ganz besonders bevorzugt 720. Dabei wird bevorzugt der Druck nicht größer als 10 mbar eingestellt.

Generell ist es vorteilhaft, den Durchfluss f möglichst hoch zu halten und gleichzeitig den Druck möglichst klein. Der maximale Durchfluss bei gegebenem Druck ist dabei lediglich von der Pumpleistung abhängig.

Das verwendete Spülgas beim Schmelzen umfasst Gase aus der Liste der Gase Argon, Helium, Stickstoff oder Kombinationen daraus. Bevorzugt wird Argon mit einem Reinheitsgrad von größer 99,99 Vol % verwendet.

In Figur 3 Säule **C** wird das Ergebnis dieser Maßnahme gezeigt. Es sind mehr als 99% der Wafer frei von Pinholes.

In einer weiteren Ausführungsform wurde der Druck (und damit auch der Durchfluss des Spülgases) erhöht, sobald das erste Polysilizium flüssig geworden ist. Die Druckerhöhung betrug dabei 4 mbar, bevorzugt 8 mbar, und ganz besonders bevorzugt 12 mbar.

Der Schmelzvorgang wurde dabei mit einer Kamera beobachtet, die mittels geeigneter Methoden der digitalen Bildverarbeitung den Zeitpunkt bestimmt, ab dem das erste Silizium flüssig geworden ist.

Die Erfinder haben erkannt, dass der Zeitpunkt, bei dem eine signifikante Erhöhung der Helligkeit der ausgewerteten Bilddaten festgestellt werden kann, sehr gut mit dem Zeitpunkt des Beginns des Phasenübergangs von Fest nach Flüssig zu korrelieren ist.

In Figur 2 wird zum Beispiel die Helligkeit als Funktion der Zeit dargestellt. Es zeigte sich, dass bevorzugt in dem Zeitpunkt zwischen den Bereichen (201) und (202) der Druck zu erhöhen ist, um eine weitere positive Wirkung hinsichtlich der Dichte von Pin-holes und der Konzentration von Kohlenstoff und Eisen zu erreichen.

In Figur 3 in Säule **D** sind die Ergebnisse von Kristallen dargestellt, die mit oben beschriebenen erfindungsgemäßen Mitteln erreicht wurden. Hier sind mehr als 99, 8% der Wafer frei von Pinholes.

In einer zusätzlichen Ausführungsform wurde beim Einrichten Polysilizium verwendet, das einen Chlorgehalt von mehr als1 ppba hatte.

Die Erfinder haben dabei erkannt, dass überraschenderweise der Einsatz von Polysilizium mit einem Chlorgehalt von größer als 1 pbba weitere positive Auswirkungen auf die Kontamination mit Eisen hat, obwohl der Fachmann annehmen würde, dass Chlor bei hohen Temperaturen Eisen aus der Anlage freisetzen und das Silizium verunreinigen müsste. Die so erreichte Kontamination von Fe konnte mit kleiner $5{,}0 \times 10^9$ at/cm$^3$ bestimmt werden.

**Patentansprüche**

1. Kristallstück aus monokristallinem Silicium, das zur Herstellung von Halbleiterscheiben vorgesehen ist,

   mit einer Länge von nicht weniger als 8 cm und nicht mehr als 50 cm und einem Durchmesser nicht kleiner als 280 mm und nicht größer als 320 mm, **dadurch gekennzeichnet, dass** eine Messung ergibt, dass der Anteil der daraus hergestellten Halbleiterscheiben, die frei sind von Pinholes mit einer Größe von nicht mehr als 30 $\mu$m und größer als 7 $\mu$m, größer ist als 98 %, wobei die Messung in gegebener Reihenfolge umfasst

   (a) das Untersuchen des Kristallstückes mittels Ultraschallmessung, wobei die Koordinaten von gefundenen Unregelmäßigkeiten gespeichert werden,
   (b) das Herstellen von Halbleiterscheiben aus dem Kristallstück mittels einer Multi-Wire-Saw,
   (c) das Untersuchen aller Halbleiterscheiben mittels einer ersten IR-Messung und das ortsaufgelöste Speichern der Ergebnisse der ersten IR-Messung,
   (d) das Polieren aller Halbleiterscheiben mittels einer Doppelseitenpolitur und anschließende Untersuchen aller Halbleiterscheiben mittels einer zweiten IR-Messung und das ortsaufgelöste Speichern der Ergebnisse der zweiten IR-Messung,
   (e) das chemisch mechanische Polieren aller Halbleiterscheiben und die anschließende Messung mittels SIRD, wobei die Ergebnisse ortsaufgelöst gespeichert werden
   (f) einer Lichtstreumessung der jeweiligen Vorder- und Rückseite aller Halbleiterscheiben und das ortsaufgelöste Speichern der so ermittelten Daten und
   (g) die Analyse aller so gewonnen Messergebnisse.

2. Kristallstück nach Anspruch 1, **dadurch gekennzeichnet,**
   **dass** das Kristallstück interstitiellen Sauerstoff von nicht weniger als $1 \times 10^{17}$ at/cm$^3$ bevorzugt nicht weniger als $3 \times 10^{17}$ at/cm$^3$ und nicht mehr als $7 \times 10^{17}$ at/cm$^3$, bevorzugt $6 \times 10^{17}$ at/cm$^3$ (new ASTM) enthält.

3. Kristallstück nach einem der vorhergehenden Ansprüche, **dadurch gekennzeichnet,**
   **dass** alle Halbleiterscheiben aus dem Anteil der hergestellten Halbleiterscheiben sowohl ein Gebiet $P_i$ aufweisen, bei dem Silizium Zwischengitteratome dominieren als auch ein Gebiet $P_v$ aufweisen, bei dem Silizium Leerstellen dominieren.

4. Kristallstück nach Anspruch 3, **dadurch gekennzeichnet, dass** die Summe aus der Fläche des Gebiets $P_v$ und der Fläche des Gebiets $P_i$ größer ist als 95%, bevorzugt 99% der Fläche der Halbleiterscheibe.

5. Kristallstück nach Anspruch 3, **dadurch gekennzeichnet, dass** die Fläche des Gebietes $P_v$ kleiner ist als 10% der Fläche der Halbleiterscheibe.

6. Kristallstück nach einem der vorhergehenden Ansprüche, **dadurch gekennzeichnet,**
   **dass** die Verunreinigung an Kohlenstoff (C) kleiner ist als $7 \times 10^{14}$ at/cm$^3$ bevorzugt kleiner als $5{,}5 \times 10^{14}$ at/cm$^3$

und zugleich die Verunreinigung an Eisen (Fe) kleiner ist als $1{,}0 \times 10^{10}$ at/cm$^3$ bevorzugt kleiner als $5{,}0 \times 10^9$ at/cm$^3$.

7. Kristallstück nach einem der vorhergehenden Ansprüche, **dadurch gekennzeichnet**,
der Widerstand gemessen an allen Halbleiterscheiben nicht kleiner ist als ist als 1 mOhmcm und nicht größer ist als größer als 1 Ohmcm.

8. Verfahren zur Herstellung von Halbleiterscheiben, **dadurch gekennzeichnet, dass** ein Kristallstück nach einem der Ansprüche 1 bis 7 verwendet wird,

mittels einer Drahtsäge zu Halbleiterscheiben geschnitten,
poliert und optional einer Epitaxie unterzogen wird.

**Claims**

1. Crystal piece of monocrystalline silicon which is intended for the production of semiconductor wafers, having a length of not less than 8 cm and not more than 50 cm and a diameter of not less than 280 mm and not greater than 320 mm, **characterized in that** a measurement shows that the fraction of the semiconductor wafers produced therefrom that are free from pinholes having a size of not more than 30 $\mu$m and greater than 7 $\mu$m is greater than 98%, where the measurement comprises, in the order given:(a) analysing the crystal piece with an ultrasound measurement, with the coordinates of irregularities found being stored, (b) producing semiconductor wafers from the crystal piece by means of a multi-wire saw, (c) analysing all of the semiconductor wafers by means of a first IR measurement and storing the results of the first IR measurement with spatial resolution,(d) polishing all of the semiconductor wafers by means of double-side polishing and then analysing all of the semiconductor wafers by means of a second IR measurement and storing the results of the second IR measurement with spatial resolution,(e) chemical-mechanically polishing all of the semiconductor wafers and then subjecting them to SIRD measurement, the results being stored with spatial resolution, (f) measuring the front side and the back side of all of the semiconductor wafers by light scattering and storing the resulting data with spatial resolution, and (g) analysing all of the measurement results thus obtained.

2. Crystal piece according to Claim 1, **characterized in that** the crystal piece comprises interstitial oxygen at not less than $1 \times 10^{17}$ at/cm$^3$, preferably not less than $3 \times 10^{17}$ at/cm$^3$ and not more than $7 \times 10^{17}$ at/cm$^3$, preferably $6 \times 10^{17}$ at/cm$^3$ (new ASTM).

3. Crystal piece according to either of the preceding claims, **characterized in that** all the semiconductor wafers from the fraction of the semiconductor wafers produced have both a region $P_i$ in which silicon interstitials are dominant and a region $P_v$ in which silicon vacancies are dominant.

4. Crystal piece according to Claim 3, **characterized in that** the sum of the area of the region $P_v$ and the area of the region $P_i$ is greater than 95%, preferably 99%, of the area of semiconductor wafer.

5. Crystal piece according to Claim 3, **characterized in that** the area of the region $P_v$ is less than 10% of the area of the semiconductor wafer.

6. Crystal piece according to any of the preceding claims, **characterized in that** the carbon (C) impurity is less than $7 \times 10^{14}$ at/cm$^3$, preferably less than $5.5 \times 10^{14}$ at/cm$^3$, and at the same time the iron (Fe) impurity is less than $1.0 \times 10^{10}$ at/cm$^3$, preferably less than $5.0 \times 10^9$ at/cm$^3$.

7. Crystal piece according to any of the preceding claims, **characterized in that** the resistance measured on all the semiconductor wafers is not less than 1 mohmcm and not greater than 1 ohmcm.

8. Method for producing semiconductor wafers, **characterized in that** a crystal piece according to any of Claims 1 to 7 is used, is cut by means of a wire saw into semiconductor wafers, is polished and is subjected optionally to epitaxy.

**Revendications**

1. Pièce de cristal en silicium monocristallin, qui est prévue pour la fabrication de tranches semiconductrices,

ayant une longueur non inférieure à 8 cm et non supérieure à 50 cm et un diamètre non inférieur à 280 mm et non supérieur à 320 mm,

**caractérisée en ce que**

une mesure donne que la proportion des tranches semiconductrices fabriquées à partir de cette pièce, qui sont exemptes de trous d'épingle ayant une grosseur non supérieure à 30 $\mu$m et supérieure à 7 $\mu$m, est supérieure à 98 %, la mesure comprenant, dans l'ordre indiqué,

(a) l'examen de la pièce de cristal par une mesure aux ultrasons, les coordonnées des irrégularités constatées étant stockées,

(b) la fabrication de tranches semiconductrices à partir de la pièce de cristal à l'aide d'une scie multi-fils,

(c) l'examen de toutes les tranches semiconductrices à l'aide d'une première mesure IR, et le stockage à résolution spatiale des résultats de la première mesure IR,

(d) le polissage de toutes les tranches semiconductrices par un polissage double face, puis l'examen de toutes les tranches semiconductrices par une deuxième mesure IR, et le stockage à résolution spatiale des résultats de la deuxième mesure IR,

(e) le polissage chimico-mécanique de toutes les tranches semiconductrices, puis une mesure par dépolarisation infrarouge SIRD, les résultats étant stockés à résolution spatiale,

(f) une mesure par diffraction de la lumière de la face avant et de la face arrière de toutes les tranches semiconductrices, et le stockage à résolution spatiale des données ainsi déterminées, et

(g) l'analyse de tous les résultats de mesure ainsi obtenus.

2. Pièce de cristal selon la revendication 1, **caractérisée en ce que** la pièce de cristal contient de l'oxygène interstitiel en une quantité non inférieure à $1 \times 10^{17}$ at/cm$^3$, de préférence non inférieure à $3 \times 10^{17}$ at/cm$^3$, et non supérieure à $7 \times 10^{17}$ at/cm$^3$, de préférence $6 \times 10^{17}$ at/cm$^3$ (nouvel ASTM).

3. Pièce de cristal selon l'une des revendications précédentes, **caractérisée en ce que**
toutes les tranches semiconductrices provenant de la portion des tranches semiconductrices fabriquées présentent également un domaine $P_i$, dans lequel dominent des atomes interstitiels de silicium, ainsi qu'un domaine $P_v$, dans lequel dominent des lacunes de silicium.

4. Pièce de cristal selon la revendication 3, **caractérisée en ce que** la somme de l'aire du domaine $P_v$ et de l'aire du domaine $P_i$ est supérieure à 95 %, de préférence supérieure à 99 % de l'aire de la tranche semiconductrice.

5. Pièce de cristal selon la revendication 3, **caractérisée en ce que** l'aire du domaine $P_v$ est inférieure à 10 % de l'aire de la tranche semiconductrice.

6. Pièce de cristal selon l'une des revendications précédentes, **caractérisée en ce que**
l'impureté carbone (C) est inférieure à $7 \times 10^{14}$ at/cm$^3$, de préférence inférieure à $5,5 \times 10^{14}$ at/cm$^3$, et simultanément l'impureté fer (Fe) est inférieure à $1,0 \times 10^{10}$ at/cm$^3$, de préférence inférieure à $5,0 \times 10^{9}$ at/cm$^3$.

7. Pièce de cristal selon l'une des revendications précédentes, **caractérisée en ce que**
la résistance, mesurée sur toutes les tranches semiconductrices, n'est pas inférieure à 1 mOhm.cm et n'est pas supérieure à 1 Ohm.cm.

8. Procédé de fabrication de tranches semiconductrices, **caractérisé en ce qu'**on utilise une pièce de cristal selon l'une des revendications 1 à 7, on la découpe avec une scie à fils pour obtenir des tranches semiconductrices, et éventuellement on la soumet à une épitaxie.

Figur 1

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5954873 A
- WO 9845508 A1
- DE 102006032431 A1
- US 9665931 A1
- US 20080032429 A1
- US 20080163140 A1
- EP 2471980 A1
- US 2011304081 A1
- DE 10339792 A1
- JP 5009097 A
- US 2011214603 A1

- EP 2725122 A
- EP 2711446 A
- WO 18149631 A1
- DE 102013212850 A1
- DE 102008045534 B4
- US 2003054650 A1
- DE 10007390 A1
- WO 19020387 A1
- DE 102017215705 A1
- US 7829467 B2
- DE 102014217514 A1